# DEMANDE DE BREVET EUROPEEN

(11) **EP 0 616 292 A1**
(43) Date de publication de la demande: **21.09.1994**
(21) Numéro de dépôt: 94400514.9
(22) Date de dépôt: 09.03.1994
(51) Int. Cl.: G06J 1/00, G06G 7/163, G01R 21/133

(54) **Circuit multiplicateur à réseaux de résistances et compteur d'énergie électrique incorporant un tel circuit**

(30) Priorité: 12.03.1993 FR 9302882
(71) Demandeur: SAGEM SA, F-75783 Paris Cédex 16 (FR)
(72) Inventeur: Pradel, Denis, F-95480 Pierrelaye (FR)
(74) Mandataire: Loisel, Bertrand

(57) **Abrégé**

Le circuit comprend deux modules multiplicateurs (M1, M2) comprenant chacun au moins un potentiomètre (P1, P2) commandable pour régler le rapport d'amplitude entre un signal de sortie (Vs, V'2) et un signal d'entrée (V1, Vr) du module. Les potentiomètres ont des caractéristiques sensiblement identiques et sont commandés de la même manière de sorte que les rapports d'amplitude des modules multipli- cateurs sont sensiblement égaux. L'un des modules (M1) reçoit comme signal d'entrée le premier signal à multiplier (V1) et délivre un signal de sortie (Vs) proportionnel au produit des deux opérandes, tandis que l'autre module (M2) reçoit comme signal d'entrée une tension de référence (Vr) et délivre comme signal de sortie un signal de rétroaction (V'2) qui est asservi à une valeur approximativement égale à celle du second signal à multiplier (V2).

Utilisation dans des compteurs d'énergie électrique.

## Description

La présente invention concerne un circuit électronique pour réaliser le produit de deux signaux de tension.

L'invention trouve une application particulière dans les compteurs d'énergie électrique alternative destinés à mesurer l'énergie consommée, par exemple par les abonnés au secteur. Dans ce cas, les signaux de tension à multiplier représentent la tension et le courant fournis dans une charge constituée par les installations électriques montées en aval du compteur.

On connait des circuits multiplicateurs de tensions entièrement analogiques utilisant des amplificateurs à réponses logarithmiques et exponentielles. Ces amplificateurs nécessitent des compensations thermiques et temporelles qui induisent des défauts de linéarité et des décalages d'autant plus importants que les signaux à multiplier sont faibles. Ces compensations sont difficiles à réaliser de façon précise sur toute la plage de fonctionnement du circuit.

On connait également des circuits multiplicateurs à potentiomètre, dans lesquels l'une des tensions à multiplier est convertie en une valeur numérique servant à commander la position du curseur du potentiomètre. Le potentiomètre est soumis à l'autre tension à multiplier, et sa sortie délivre donc le signal proportionnel au produit. Lorsqu'une résolution importante est recherchée, le potentiomètre doit comporter un nombre élevé de résistances connectées en série. Pour que la réponse du circuit soit linéaire, il est nécessaire que les différentes résistances aient des caractéristiques aussi uniformes que possible. Cette condition est d'autant plus difficile à réaliser qu'il y a un nombre élevé de résistances dans le potentiomètre. Les circuits à potentiomètre connus sont donc difficiles à optimiser à la fois en termes de résolution et de linéarité.

Le but de la présente invention est de proposer un circuit multiplicateur à potentiomètre ayant une meilleure linéarité à résolution donnée, et qui convienne particulièrement pour une réalisation sous forme de circuit intégré.

Le circuit selon l'invention comprend deux modules multiplicateurs comprenant chacun au moins un potentiomètre commandable pour régler le rapport d'amplitude entre un signal de sortie et un signal d'entrée du module multiplicateur, chaque potentiomètre étant constitué par un réseau de résistances en série associé à un ensemble d'interrupteurs montés chacun entre un noeud respectif du réseau de résistances et une sortie commune du potentiomètre. Les potentiomètres ont des caractéristiques sensiblement identiques et sont commandés de la même manière par une unité de commande séquentielle, de sorte que les rapports d'amplitude des modules multiplicateurs sont constamment sensiblement égaux. Un premier module multiplicateur reçoit comme signal d'entrée le premier signal de tension et délivre un signal de sortie proportionnel au produit des deux opérandes. Le second module multiplicateur reçoit comme signal d'entrée une tension de référence et délivre comme signal de sortie un signal de rétroaction. Le circuit comprend en outre des moyens pour comparer le signal de rétroaction au second signal de tension et, en cas d'écart significatif entre ces deux signaux, produire des signaux de correction adressés à l'unité de commande séquentielle pour modifier de façon correspondante les rapports d'amplitude.

La linéarité de la réponse résulte de l'identité des rapports d'amplitude des deux modules multiplicateurs. Cette identité peut être obtenue avec une précision élevée car elle ne dépend que de l'identité des caractéristiques des résistances de même rang au sein des potentiomètres. Or, notamment dans la technique des circuits intégrés, l'une des précisions les plus grandes qu'on puisse obtenir sans réglage est rencontrée dans l'appariement des valeurs de deux résistances géométriquement semblables, voisines et imbriquées. Ainsi, les rapports d'amplitude des deux modules peuvent être rendus pratiquement égaux en appariant les résistances de même rang des potentiomètres. La précision dans l'identité des rapports d'amplitude est d'ailleurs d'autant plus grande que les potentiomètres comportent un nombre élevé de résistances. En effet, la différence entre les rapports d'amplitude est une moyenne des erreurs sur les rapports unitaires des résistances prises deux à deux. Statistiquement, cette moyenne est d'autant plus faible que le nombre de résistances est important.

L'invention concerne également un compteur d'énergie électrique alternative consommée dans une charge, comprenant des moyens pour fournir deux signaux de tension, l'un proportionnel à la tension appliquée à la charge, l'autre proportionnel à l'intensité du courant qui traverse la charge, un circuit multiplicateur du type défini ci-dessus, délivrant un signal de puissance proportionnel au produit algébrique des deux signaux de tension, et des moyens exploitant le signal de puissance pour fournir une indication de l'énergie électrique consommée dans la charge.

D'autres particularités et avantages de la présente invention apparaîtront dans la description ci-après d'exemples de réalisation préférés et non limitatifs. Aux dessins annexés :
- les figures 1 et 2 sont des schémas représentant respectivement deux formes de réalisation d'un circuit multiplicateur selon l'invention ;
- les figures 3 et 4 représentent deux variantes de réalisation des modules multiplicateurs du circuit de la figure 2 ; et
- la figure 5 est un schéma d'un compteur d'énergie électrique suivant l'invention.

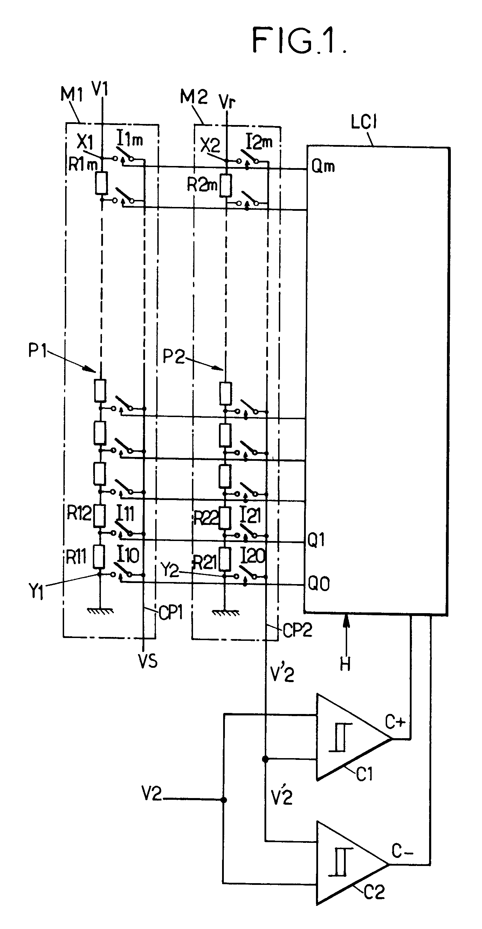

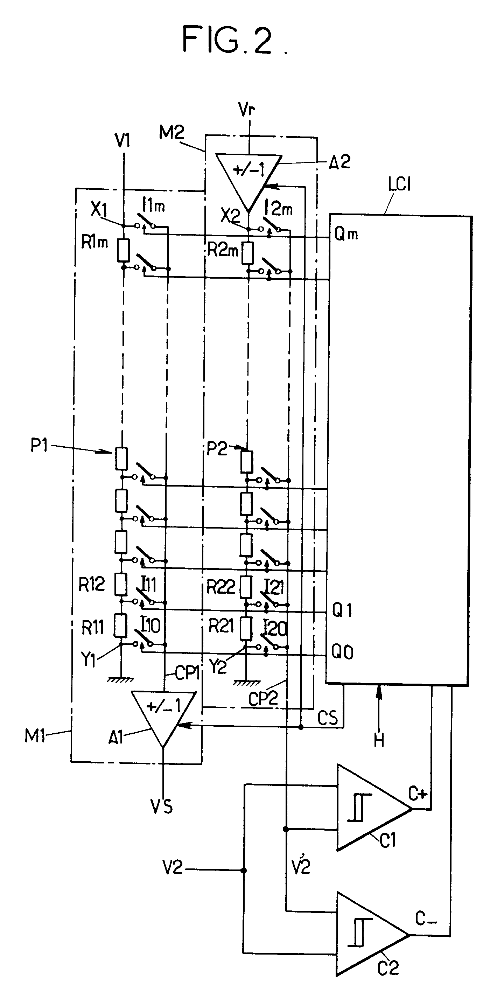

Les circuits électroniques représentés aux figures 1 et 2 comprennent chacun deux modules multiplicateurs M1 et M2. Le premier module M1 reçoit comme signal d'entrée un signal de tension V1 représentatif du premier opérande à multiplier, et délivre un signal de sortie Vs proportionnel à V1 avec un rapport d'amplitude k1 = | Vs/V1| . Le second module M2 reçoit comme signal d'entrée une tension de référence constante Vr et délivre comme signal de sortie un signal de rétroaction V'2 proportionnel à Vr avec un rapport d'amplitude k2 = | V'2/Vr| .

Les rapports Vs/V1 et V'2/Vr sont réglés par une unité de commande séquentielle LCI cadencée par un signal d'horloge H.

Le circuit comporte en outre deux comparateurs C1, C2 ayant chacun deux entrées recevant respectivement le signal de rétroaction V'2 issu du second module M2 et un signal de tension V2 représentatif du second opérande à multiplier. Le comparateur C1 délivre un signal C+ représentant la différence V2 - V'2 lorsqu'elle est positive. Le comparateur C2 délivre un signal C- représentatif de la différence V2 - V'2 lorsqu'elle est négative. Ces deux signaux C+, C- sont deux signaux de correction respectivement adressés à une entrée d'incrémentation et à une entrée de décrémentation de l'unité de commande séquentielle LCI. L'unité LCI comprend un compteur qui, à chaque période du signal d'horloge H, est incrémenté d'une valeur correspondant au signal de correction C+, ou décrémenté d'une valeur correspondant au signal de correction C-. La période du signal d'horloge H est choisie inférieure à l'échelle de temps des variations du signal de tension V2. L'unité de commande séquentielle commande les modules M1, M2 en fonction de la valeur du compteur comme il sera expliqué plus loin.

Dans l'exemple réprésenté à la figure 1, les deux modules M1, M2 sont chacun constitués par un potentiomètre P1, P2. Les potentiomètres P1 et P2 sont de constitution identique. Ils comprennent chacun un réseau de m résistances en série R11, R12,..., R1m [R21, R22, ..., R2m] connecté entre une borne X1 [X2] recevant le signal d'entrée V1 [Vr] du module et une borne opposée Y1 [Y2] reliée à la masse, et associé à un ensemble de m + 1 interrupteurs I10, I11, ..., I1m [I20, I21, ..., I2m]. L'interrupteur I1j [I2j] (O < j < m) est monté entre un noeud du réseau correspondant situé entre les résistances R1j et R1(j+1) [R2j et R2(j+1)] et une sortie commune CP1 [CP2] formant le curseur du potentiomètre. L'interrupteur I10 [I20] est monté entre un noeud du réseau correspondant constitué par sa borne Y1 [Y2] et la sortie CP1 [CP2]. L'interrupteur I1m [I2m] est monté entre un noeud du réseau correspondant constitué par sa borne X1 [X2] et la sortie CP1 [CP2].

Pour chaque indice j compris entre 1 et m, les résistances R1j et R2j sont appariées de manière à avoir des caractéristiques (valeurs ohmiques) sensiblement identiques. Lorsque le circuit est réalisé sous forme intégrée, chaque résistance peut être constituée par une zone de silicium à dopage contrôlé ayant des dimensions de l'ordre de quelques dizaines de microns. Les résistances appariées ont alors des caractéristiques géométriques aussi semblables que possible et sont disposées de manière spatialement imbriquée. Pour chaque indice j compris entre O et m, les interrupteurs I1j et T2j sont dans la même position (ouverture ou fermeture) commandée par un signal Qj issu de l'unité de commande séquentielle LCI. Ainsi, les rapports d'amplitude k1, k2 des modules multiplicateurs sont constamment sensiblement égaux.

L'unité de commande séquentielle LCI élabore les signaux Q0, Q1, ..., Qm en fonction de la valeur de son compteur de façon qu'il n'y ait toujours qu'une seule paire d'interrupteurs I1j, I2j qui soit fermée. Les comparateurs C1, C2 et l'unité LCI réalisent un asservissement continu du rapport d'amplitude k1 à la valeur V2/Vr. Ainsi, le signal de sortie Vs du circuit est égal à V1 x V2/Vr, avec une précision de l'ordre de 1/m. L'écart significatif que doivent permettre de détecter les comparateurs C1 et C2 entre les signaux V2 et V'2 est de l'ordre de Vr/m.

Le nombre m de résistances par potentiomètre est choisi en fonction de la précision recherchée. Si toutes les résistances pouvaient avoir exactement la même valeur ohmique, on aurait k1 = k2 = j/m, où j désigne l'indice de la paire d'interrupteurs fermés à l'instant considéré. Dans la pratique, la reproductibilité des caractéristiques sur un grand nombre de résistances est difficile à obtenir mais, avec la disposition consistant à apparier les résistances de même rang des potentiomètres P1, P2, on obtient une très bonne identité entre les rapports k1 et k2, même si ces rapports peuvent différer légèrement de la valeur j/m. En outre, pour les raisons statistiques évoquées précédemment, l'identité entre les rapports k1 et k2 est même meilleure que celle entre les valeurs ohmiques des résistances appariées.

Dans l'exemple représenté à la figure 1, le signal de sortie Vs a toujours le même signe que le signal de tension V1, du moins lorsque Vr est positive, de sorte que ce circuit permet une multiplication sur deux quadrants (V2 > 0).

On notera qu'un circuit analogue à celui de la figure 1 peut être utilisé pour réaliser une multiplication sur quatre quadrants. Il suffit de ne pas relier à la masse les bornes Y1, Y2 des potentiomètres P1, P2, mais de leur adresser respectivement l'inverse -V1 du premier signal de tension V1, et l'inverse -Vr de la tension de référence Vr. La multiplication sur quatre quadrants est alors obtenue avec un fonctionnement analogue, la résolution étant toutefois divisée par 2 pour un même nombre m de résistances.

La figure 2 représente une autre manière de réaliser une multiplication sur quatre quadrants.

Dans ce circuit, le premier module multiplicateur M1 comporte un amplificateur à gain variable A1 dont l'entrée est reliée à la sortie CP1 du potentiomètre P1, et dont la sortie délivre le signal de sortie Vs, et le second module multiplicateur M2 comprend un amplificateur à gain variable A2 dont l'entrée reçoit la tension de référence Vr et dont la sortie est reliée à la borne X2 du potentiomètre P2. Le gain de chacun des amplificateurs A1, A2 peut prendre la valeur +1 ou -1 en réponse à un signal binaire de commande de signe CS issu de l'unité de commande séquentielle LCI. Le signal CS commande donc le signe des rapports Vs/V1 et V'2/Vr. L'unité LCI élabore le signal de commande de signe CS de façon telle que le gain de l'amplificateur A2 soit égal à -1 ou +1 lorsque la valeur de son compteur est négative ou positive, respectivement. Le même signe est alors imposé à l'amplificateur A1, de sorte qu'on a Vs = +V1 x V2/Vr quels que soient les signes de V1 et V2 (on pourrait également imposer à A1 un gain de signe contraire, auquel cas on aurait Vs = -V1 x V2/Vr).

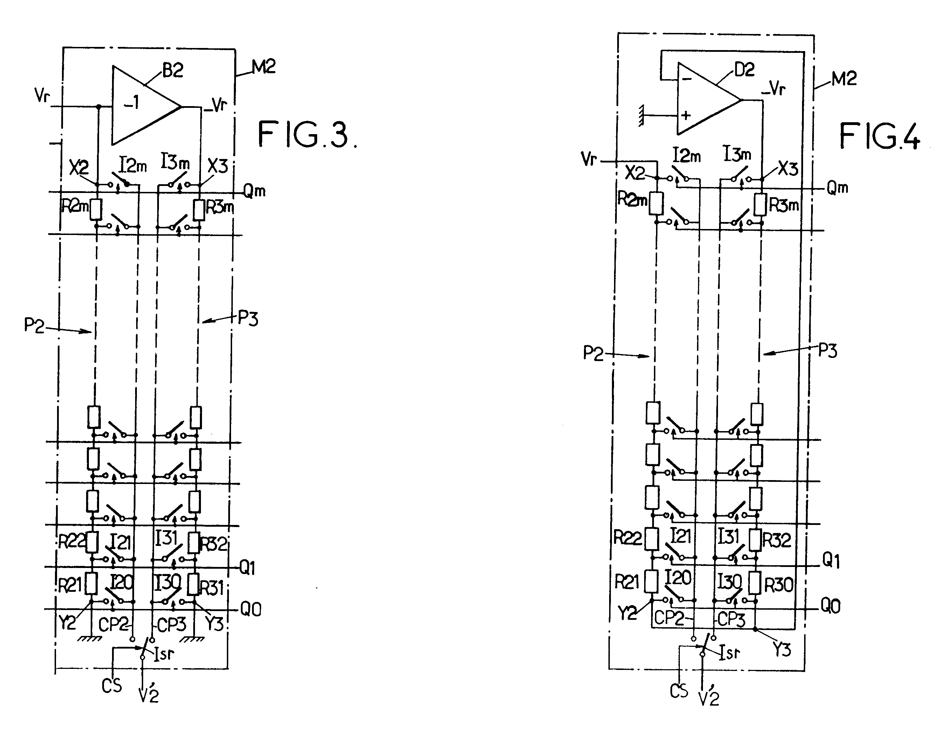

La figure 3 représente une variante de réalisation du second module multiplicateur M2 de la figure 2. Le module M2 représenté à la figure 3 comprend, outre le potentiomètre P2, un second potentiomètre P3 qui a également une constitution sensiblement identique à celle des potentiomètres P1 et P2 (résistances R31, R32, ..., R3m montées en série entre deux bornes X3, Y3 ; interrupteurs I30, I31, ..., I3m reliés à la sortie commune CP3). La borne X2 du potentiomètre P2 reçoit la tension de référence Vr, tandis que la borne correspondante X3 du potentiomètre P3 reçoit l'inverse -Vr de la tension de référence, obtenu en sortie d'un inverseur B2. Un commutateur Isr relie sélectivement une borne où le signal de sortie V'2 du module est produit à l'une ou l'autre des deux sorties CP2, CP3 des deux potentiomètres P2, P3, en réponse au signal de commande de signe CS issu de l'unité LCI. La sortie CP2 est à la tension k2 x Vr, tandis que la sortie CP3 est à la tension -k2 x Vr, la sortie sélectionnée par le commutateur Isr dépendant du signe du signal de tension V2.

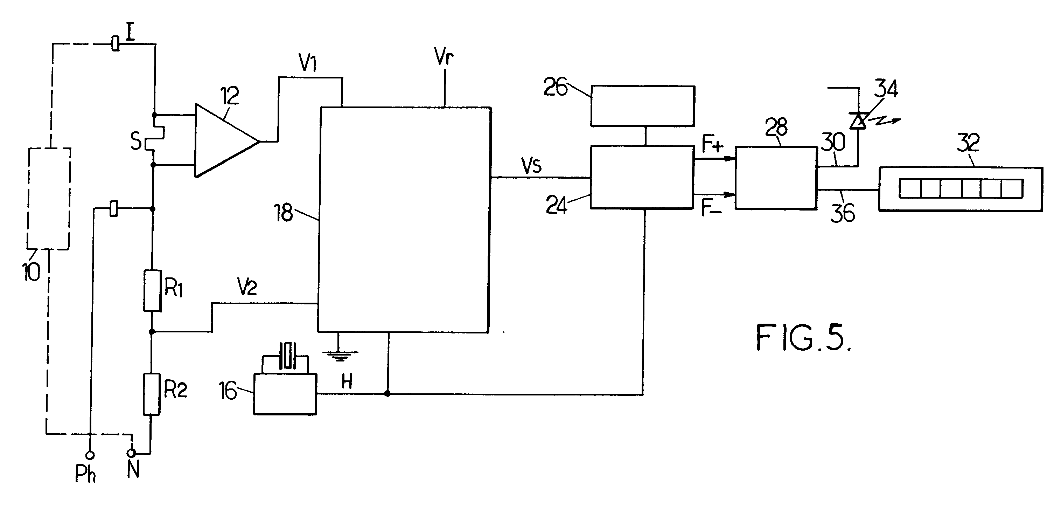

La figure 4 montre une manière avantageuse de réaliser un inverseur utilisable à la place de l'inverseur B2 de la figure 3. Cet inverseur comprend un amplificateur D2 dont l'entrée positive est reliée à la masse, l'entrée négative est reliée aux deux extrémités correspondantes Y2, Y3 des réseaux de résistances en série des deux potentiomètres P2, P3 du module, et la sortie est reliée à la borne opposée X3 du réseau de résistances en série du potentiomètre P3, la borne X2 du potentiomètre P2 recevant toujours la tension de référence Vr. Ainsi, la résistance totale du potentiomètre P2 constitue la résistance d'entrée de l'inverseur, tandis que la résistance totale du potentiomètre P3 constitue la résistance de rétroaction de l'inverseur. Les valeurs de ces deux résistances totales sont identiques avec un degré de précision très élevé car leurs résistances individuelles sont appariées et le nombre de résistances dans chaque réseau réduit, statistiquement, les écarts résiduels entre les valeurs des résistances appariées.

Sur les figures 2 à 4, on a représenté quatre manières de réaliser un module multiplicateur à commande de signe. Les modules M1, M2 représentés à la figure 2 réalisent la multiplication avec commande de signe sans dédoublement des potentiomètres, et donc avec un encombrement minimal. Le module M2 représenté à la figure 3 a l'avantage d'une plus grande précision, l'inverseur (amplificateur de gain -1) introduisant moins de distorsions qu'un amplificateur à gain commandé. La précision est encore optimisée lorsque l'inverseur utilise comme résistances d'entrée et de rétroaction les résistances totales des potentiomètres (figure 4) dont les valeurs ohmiques sont rendues pratiquement identiques par construction. Dans la pratique, suivant les propriétés recherchées, on pourra donner à chacun des deux modules du circuit l'une des constitutions représentées aux figures 2 à 4, les deux modules n'ayant pas nécessairement la même constitution.

La figure 5 représente un compteur d'énergie électrique incorporant un circuit multiplicateur 18 selon l'invention. Ce compteur comporte des moyens de génération de signaux de tension analogiques de mesure V1, V2 respectivement proportionnels au courant traversant une charge 10 dont la consommation est à mesurer et à la tension aux bornes de cette charge. Le schéma de la figure 5 correspond à une alimentation de la charge en courant alternatif monophasé à partir d'une borne de neutre N et d'une borne de phase Ph. Mais le compteur peut être adapté à une alimentation polyphasée par simple duplication de ces composants avant regroupement pour affichage unique.

Les moyens de génération de V1 comportent une résistance série S parcourue par le courant qui traverse la charge 10 et un préamplificateur différentiel 12 dont les entrées sont reliées aux bornes de la résistance S et dont la sortie délivre le premier signal de tension V1.

Les moyens de génération de V2 comportent un pont diviseur R1-R2 dont le point milieu fournit V2. Les résistances R1 et R2 sont choisies de façon à ce que V2 soit compatible avec le fonctionnement du circuit multiplicateur.

Le circuit 18 assure la multiplication sur quatre quadrants des signaux V1 et V2. Il peut par exemple être conforme à celui représenté à la figure 2, éventuellement avec les variantes représentées aux figures 3 et 4. Le circuit 18 reçoit la tension de référence Vr et le signal d'horloge H issu d'une horloge 16. Son signal de sortie Vs, représentatif de la puissance instantanée, attaque un convertisseur tension-fréquence 24 cadencé par le signal d'horloge H, qui convertit les valeurs successives de Vs en impulsions représentant chacune un quantum d'énergie sur des sorties F+ et F-, suivant que l'énergie est positive ou négative, c'est-à-dire suivant le signe de Vs. Le convertisseur 24 peut avoir une constitution classique et comporter notamment un intégrateur analogique d'entrée associé à un générateur de facteur d'échelle 26 déterminant le coefficient de proportionnalité entre Vs et la fréquence de sortie F. Dans le mode de réalisation illustré à la figure 5, où l'affichage de sortie comprend un voyant 34 donnant une impulsion lumineuse à chaque incrémentation d'une énergie déterminée (par exemple 1 Wh) et un compteur totalisateur 32, un bloc 28 est prévu pour effectuer une division de fréquence entre la fréquence de sortie des impulsions F+ et F-, afin de fournir d'une part, sur une sortie 30 commandant le voyant 34, des impulsions pour chaque incrémentation à visualiser, et d'autre part, sur une sortie 36 attaquant le compteur totalisateur 32, une impulsion pour chaque incrément correspondant à un accroissement d'une unité du chiffre le moins significatif sur le compteur totalisateur 32.

## Revendications

1. Circuit électronique pour réaliser le produit de deux opérandes représentés par des premier et second signaux de tension (V1, V2), caractérisé en ce qu'il comprend deux modules multiplicateurs (M1, M2) comprenant chacun au moins un potentiomètre (P1, P2) commandable pour régler le rapport d'amplitude (k1, k2) entre un signal de sortie (Vs, V'2) et un signal d'entrée (V1, Vr) du module multiplicateur, chaque potentiomètre étant constitué par un réseau de résistances en série (R11,..., R1m ; R21,..., R2m) associé à un ensemble d'interrupteurs (I10,..., I1m ; I20,..., I2m) montés chacun entre un noeud respectif du réseau de résistances et une sortie commune (CP1, CP2) du potentiomètre, en ce que les potentiomètres ont des caractéristiques sensiblement identiques et sont commandés de la même manière par une unité de commande séquentielle (LCI), de sorte que les rapports d'amplitude (k1, k2) des modules multiplicateurs sont constamment sensiblement égaux, en ce qu'un premier module multiplicateur (M1) reçoit comme signal d'entrée le premier signal de tension (V1) et délivre un signal de sortie (Vs) proportionnel au produit des deux opérandes, tandis que le second module multiplicateur (M2) reçoit comme signal d'entrée une tension de référence (Vr) et délivre comme signal de sortie un signal de rétroaction (V'2), et en ce que le circuit comprend en outre des moyens (C1, C2) pour comparer le signal de rétroaction (V'2) au second signal de tension (V2) et, en cas d'écart significatif entre ces deux signaux (V'2, V2), produire des signaux de correction (C+, C-) adressés à l'unité de commande séquentielle (LCI) pour modifier de façon correspondante les rapports d'amplitude (k1, k2).

2. Circuit selon la revendication 1, pour une multiplication sur deux quadrants, caractérisé en ce que le premier module multiplicateur (M1) comprend un potentiomètre unique (P1) dont le réseau de résistances a une borne (X1) recevant le premier signal de tension (V1) et une borne opposée (Y1) reliée à la masse, le signal de sortie (Vs) étant disponible à la sortie (CP1) de ce potentiomètre, et en ce que le second module multiplicateur (M2) comprend un potentiomètre unique (P2) dont le réseau de résistances a une borne (X2) portée à la tension de référence (Vr) et une borne opposée (Y2) reliée à la masse, le signal de rétroaction (V'2) étant disponible à la sortie (CP2) de ce potentiomètre.

3. Circuit selon la revendication 1, pour une multiplication sur quatre quadrants, caractérisé en ce que le premier module multiplicateur (M1) comprend un potentiomètre unique (P1) dont le réseau de résistances a une borne (X1) recevant le premier signal de tension (V1) et une borne opposée (Y1) recevant l'inverse (-V1) du premier signal de tension, le signal de sortie (Vs) étant disponible à la sortie (CP1) de ce potentiomètre, et en ce que le second module multiplicateur (M2) comprend un potentiomètre unique (P2) dont le réseau de résistances a une borne (X2) portée à la tension de référence (Vr) et une borne opposée (Y2) portée à l'inverse (-Vr) de la tension de référence, le signal de rétroaction (V'2) étant disponible à la sortie (CP2) de ce potentiomètre.

4. Circuit selon la revendication 1, pour une multiplication sur quatre quadrants, caractérisé en ce que chaque module multiplicateur (M1, M2) comprend des moyens de sélection de signe respectifs (A1, A2 ; Isr) commandables pour fixer le signe du rapport (Vs/V1, V'2/Vr) entre son signal de sortie et son signal d'entrée, et en ce que les moyens de sélection de signe des premier et second modules multiplicateurs sont commandés conjointement par l'unité de commande séquentielle (LCI) de façon qu'il y ait une relation prédéterminée entre les signes respectifs des rapports (Vs/V1, V'2/Vr).

5. Circuit selon la revendication 4, caractérisé en ce qu'au moins un des modules multiplicateurs (M2) comprend un potentiomètre unique (P2) et des moyens de sélection de signe constitués par un amplificateur à gain commandé (A2) dont le gain prend la valeur +1 ou -1 en réponse à un signal de commande de signe (CS) issu de l'unité de commande séquentielle (LCI), le signal d'entrée (Vr) de ce module étant adressé à une borne (X2) du réseau de résistances dudit potentiomètre unique par l'intermédiaire de cet amplificateur à gain commandé.

6. Circuit selon la revendication 4 ou 5, caractérisé en ce qu'au moins un des modules multiplicateurs (M1) comprend un potentiomètre unique (P1) et des moyens de sélection de signe constitués par un amplificateur à gain commandé (A1) dont le gain prend la valeur + 1 ou - 1 en réponse à un signal de commande de signe (CS) issu de l'unité de commande séquentielle (LCI), cet amplificateur à gain commandé ayant une entrée reliée à la sortie (CP1) dudit potentiomètre unique et une sortie produisant le signal de sortie (Vs) de ce module.

7. Circuit selon l'une quelconque des revendications 4 à 6, caractérisé en ce qu'au moins un des modules multiplicateurs (M2) comprend deux potentiomètres (P2, P3) et des moyens de sélection de signe constitués par un commutateur (Isr) reliant sélectivement une borne où le signal de sortie (V'2) du module est produit à l'une ou l'autre des deux sorties (CP2, CP3) desdits potentiomètres (P2, P3), le signal d'entrée (Vr) du module étant adressé d'une part à une borne (X2) du réseau de résistances de l'un desdits potentiomètres et d'autre part, par l'intermédiaire d'un inverseur (B2 ; D2), à une borne correspondante (X3) du réseau de résistances de l'autre desdits potentiomètres, les autres bornes (Y2, Y3) des réseaux de résistances desdits potentiomètres étant portées au potentiel de la masse.

8. Circuit selon la revendication 7, caractérisé en ce que ledit inverseur comprend un amplificateur opérationnel (D2) dont l'entrée positive est reliée à la masse, l'entrée négative est reliée à deux bornes correspondantes (Y2, Y3) des réseaux de résistances des deux potentiomètres du module, et la sortie est reliée à la borne opposée (X3) du réseau de résistances en série de l'un des potentiomètres (P3) du module, la borne opposée (X2) du réseau de résistances en série de l'autre potentiomètre (P2) recevant le signal d'entrée (Vr) du module.

9. Compteur d'énergie électrique alternative consommée dans une charge (10), comprenant des moyens (R1, R2, S, 12) pour fournir deux signaux de tension (V1, V2) l'un proportionnel à la tension appliquée à la charge, l'autre proportionnel à l'intensité du courant qui traverse la charge, un circuit multiplicateur (18) délivrant un signal de puissance (Vs) proportionnel au produit algébrique des deux signaux de tension (V1, V2), et des moyens (24, 28, 32, 34) exploitant le signal de puissance (Vs) pour fournir une indication de l'énergie électrique consommée dans la charge, caractérisé en ce que le circuit multiplicateur (18) est un circuit électronique conforme à l'une quelconque des revendications 3 à 8.
